# EUROPÄISCHE PATENTSCHRIFT

(11) **EP 2 143 185 B1**
(45) Veröffentlichungstag und Bekanntmachung des Hinweises auf die Patenterteilung: **25.04.2018**
(21) Anmeldenummer: 07722371.7
(22) Anmeldetag: 03.05.2007
(51) Int. Cl.: H02H 7/28, G01R 31/08

(54) **VERFAHREN UND VORRICHTUNG ZUR ERFASSUNG EINES FEHLERS IN EINEM ELEKTRISCHEN VERSORGUNGSNETZ**
METHOD AND DEVICE FOR CAPTURING A FAULT IN AN ELECTRICAL SUPPLY GRID
PROCÉDÉ ET DISPOSITIF DE DÉTECTION D'UN DÉFAUT DANS UN RÉSEAU D'ALIMENTATION ÉLECTRIQUE

(43) Veröffentlichungstag der Anmeldung: 13.01.2010
(73) Patentinhaber: Siemens Aktiengesellschaft, 80333 München (DE)
(72) Erfinder: DZAFIC, Izudin, 90461 Nürnberg (DE)
(86) Internationale Anmeldenummer: PCT/DE2007/000817
(87) Internationale Veröffentlichungsnummer: WO 2008/134995

(56) Entgegenhaltungen:
- EP-A- 0 045 113
- DE-A1- 10 307 972
- JP-A- 3 185 372
- JP-A- 4 000 214

## Beschreibung

Die Erfindung betrifft ein Verfahren zur Erfassung eines Fehlers, insbesondere eines Erdschlusses, in einem elektrischen Versorgungsnetz.

Bisherige Verfahren zur Erfassung eines Fehlers innerhalb eines Energieversorgungsnetzes unterscheiden zwischen ausfallrelevanten Fehlern (Outage Faults) und zwischen nicht- ausfallrelevanten Fehlern (Non-Outage Faults). Für beide Arten von Fehlererkennungen ist ein unterschiedlicher Algorithmus notwendig.

Des Weiteren ist bekannt, die Richtung eines möglichen Fehlers, insbesondere in Form eines Erdschlusses, zu ermittelt. So beschreibt exemplarisch die DE 103 07 972 B4 ein Verfahren zur Erkennung und Ortung von niederohmigen und hochohmigen Erdschlüssen in einem elektrischen Versorgungsnetz.

Nachteilig bei allen bekannten Verfahren ist, dass eine einfache und schnelle Ortung eines Fehlers in einem elektrischen Versorgungsnetz die Netzkonfiguration und die Art des möglichen Fehlers als Eingangsgröße vorliegen muss. Dies führt beispielsweise dazu, dass für die Fehlerüberwachung von ausfall- und nichtausfallrelevanten Fehlern andere Ortungsverfahren parallel bzw. nacheinander verwendet werden, was zeit- und kostenaufwändig ist.

Aus der Druckschrift JP 03 185372 A ist ein System zur Fehlerortung bekannt, bei dem Messwerte aus einem Schaltbild ausgewertet und anschließend mit simulierten Messwerten verglichen werden. Durch geeignetes Durchprobieren verschiedener Fehlerpositionen können unterschiedliche Vergleiche mit den realen Messwerten durchgeführt werden. Stimmen die simulierten Messwerte mit den realen Messwerten überein, so wird von einer korrekten Positionsermittlung für den Fehler ausgegangen. Es werden als Messwerte Spannungsmesswerte, Stromstärkemesswerte oder Phaseninformationen verglichen.

Ferner ist die Druckschrift EP-A-0 045 113 bekannt, bei der zur Ermittlung einer Fehlerposition sog. Richtungsglieder eingesetzt werden, die aus einer Simulation gewonnen werden. Voraussetzung dafür ist das Vorliegen eines Gleichstromnetzmodells für die Simulation.
Aufgabe der vorliegenden Erfindung ist es daher, ein Verfahren bereitzustellen, das keine Selektion hinsichtlich der Fehlerindikatoren benötigt und insbesondere in vermaschten Versorgungsnetzen zur Anwendung kommt.

Gelöst wird die Aufgabe durch den Gegenstand des Patentanspruchs 1. Danach ist vorgesehen, dass eine Komponente des elektrischen Versorgungsnetzes mit mindestens einer Versorgungsleitung verbunden ist, wobei die Komponente mit einem Teil der Zu- und Ableitungen der Versorgungsleitung zur Komponente zu einer virtuellen Komponente zusammengefasst wird. Im Rahmen des erfindungsgemäßen Verfahrens werden daher nicht die realen Komponenten des elektrischen Versorgungsnetzes betrachtet, sondern künstlich gebildete Komponente des Versorgungsnetzes gebildet und hinsichtlich eines möglichen Fehlers ausgewertet. Dazu wird jeder der mit der Komponente verbundenen Versorgungsleitung innerhalb der virtuellen Komponente ein Fehlerindikator zugeordnet und die Richtung eines möglichen Fehlers, insbesondere eines Erdschlusses, ermittelt.

Jedem Fehlerindikator wird anschließend in Abhängigkeit von der Richtung des Fehlers ein Korrelationskoeffizient zugewiesen. Für den Fall, dass die Richtung des Fehlers in die virtuelle Komponente verläuft wird vorteilhafterweise die Zahl +1; für den Fall das die Richtung des Fehlers aus der virtuellen Komponente zeigt die Zahl -1 vergeben. Bei einer nicht feststellbaren Richtung des Fehlers wird die Zahl 0.5 vergeben.

Die mit dem Korrelationskoeffizienten zugeordneten Fehlerindikatoren werden dann zu einem Index der virtuellen Komponenten zusammengefasst. Durch den Vergleich von zumindest zwei Indizes von virtuellen Komponenten kann der höchste Index und damit die virtuelle Komponente mit der höchsten Fehlerwahrscheinlichkeit ermittelt werden.

Gemäß einer vorteilhaften Ausführung des Verfahrens ist vorgesehen, dass die Indizes der virtuellen Komponenten bezüglich jeweils einer funktionellen Gruppe von Komponenten berechnet werden. Die Bildung der virtuellen Komponenten für das elektrische Versorgungsnetz kann auf der Grundlage von unterschiedlichen Überlegungen erfolgen. So sind beispielsweise nicht notwendigerweise alle Komponenten des Versorgungsnetzes für die Bildung der virtuellen Komponenten zu nutzen. So können beispielsweise lediglich alle Leistungsschalter im elektrischen Versorgungsnetz als Komponenten definiert und damit entsprechende virtuelle Komponenten gebildet werden. Andere Komponenten werden dann als Teil der Versorgungsleitung aufgefasst und in der Fehlerberechnung nicht berücksichtigt.

Auch eine Unterscheidung zwischen ausfallrelevanten und nicht- ausfallrelevanten Komponenten mit entsprechend definierten virtuellen Komponenten des elektrischen Versorgungsnetzes ermöglicht eine Fehlerortung für die so nur ausgewählten Komponenten. Damit können selektiv die zu betrachtenden Komponenten des elektrischen Versorgungsnetzes für die Fehlerortung in Form der virtuellen Komponenten ausgewählt werden.

Vorteilhafterweise sind die Fehlerindikatoren hinsichtlich ihrer Anzeigegenauigkeit innerhalb des elektrischen Versorgungsnetzes gewichtet und entsprechen einem alphanumerischen Wert.

In einer vorteilhaften Ausgestaltung des Verfahrens werden die Fehlerindikatoren einer virtuellen Komponente addiert und bezüglich der Anzahl der Fehlerindikatoren normiert und ergeben somit einen entsprechenden Index der virtuellen Komponente. Neben der als Beispiel angeführten arithmetischen Mittelwertbildung sind im Sinne der vorliegenden Erfindung alle mathematischen Verfahren zur Mittelwertbildung umfasst.

Es wird als Vorteil angesehen, dass die virtuelle Komponente mit dem höchsten Index automatisch ausgewählt und/oder einem Betrachter visualisiert wird. Hierdurch ist sichergestellt, dass die als fehlerbehaftet identifizierte, virtuelle Komponente einem Betrachter bzw. einem System zur genaueren Überprüfung bereitgestellt wird.

Vorteilhafterweise wird in periodischen Abständen die Richtung eines möglichen Fehlers innerhalb des betrachteten Abschnitts des elektrischen Versorgungsnetzes ermittelt.

Die Aufgabe wird ebenfalls durch eine Vorrichtung zur Durchführung des erfindungsgemäßen Verfahrens gelöst.

Des Weiteren löst ein Computerprogrammprodukt die Aufgabe, wobei das Computerprogrammprodukt in einem computerlesbaren Medium gespeichert ist und computerlesbare Mittel umfasst, mittels derer ein Computer veranlasst wird, das erfindungsgemäße Verfahren durchzuführen, wenn das Programm in dem Computer abläuft.

Weitere vorteilhafte Ausgestaltungen finden sich in den Unteransprüchen. Der Gegenstand der Erfindung wird anhand der nachfolgenden Zeichnungen erläutert. Es zeigt:
- Fig. 1a: eine schematische Darstellung einer virtuellen Komponente mit einer Komponente entsprechend dem erfindungsgemäßen Verfahren;
- Fig. 1b: eine schematische Darstellung einer virtuellen Komponente für die Verbindung zweier Komponenten entsprechend dem erfindungsgemäßen Verfahren;
- Fig. 2a: schematische Darstellung eines elektrischen Versorgungsnetzes mit dargestellten virtuellen Komponenten;
- Fig. 2b: Einzeldarstellung der virtuellen Komponenten mit den zugeordneten Korrelationskoeffizienten;
- Fig. 3: tabellarische Darstellung der gewichteten Korrelationskoeffizienten der virtuellen Komponenten bezogen auf die realen Komponenten und dem sich daraus ergebenen Indizes.

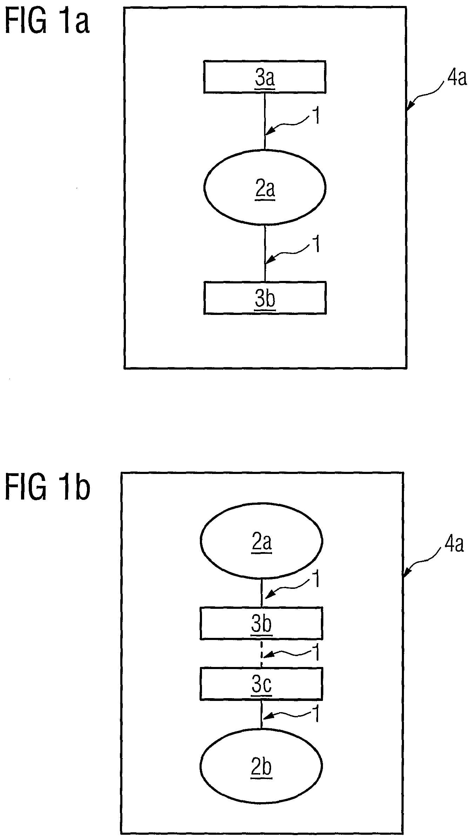

Die Figur FIG. 1a zeigt eine virtuelle Komponente 4a, in der eine Komponente 2a mit einem direkten Zu- und Abgang innerhalb des elektrischen Versorgungsnetzes 1 verbunden ist. Dem Leitungszu- und -abgang der Komponente 2a wird innerhalb der virtuellen Komponente 4a jeweils ein Fehlerindikator 3a,3b zugeordnet. Des Weiteren wird jedem Fehlerindikator 3a,3b ein Korrelationskoeffizient 5a, 5b zugeordnet, wobei der jeweilige Korrelationskoeffizient 5a,5b eine Auftrittswahrscheinlichkeit für einen entsprechenden Fehlerindikator 3a,3b innerhalb der virtuellen Komponente 4a darstellt. Der Korrelationskoeffizient 5a,5b kann dabei entweder manuell durch einen Bediener vergeben oder durch ein System anhand der Netzstruktur des elektrischen Versorgungsnetzes 1 automatisch aufgrund eines möglichen Fehlers 7 (nicht darge-Die an eine erste virtuelle Komponente 4a anschließende weitere virtuelle Komponente 4b weist auf der Verbindungsleitung 1 des elektrischen Versorgungsnetzes in Richtung der ersten virtuellen Komponente 4a ebenfalls wieder einen Fehlerindikator 3c auf. Im gezeigten Beispiel der Figur FIG.1a würde eine unterhalb der ersten virtuellen Komponente 4a angeordnete zweite virtuelle Komponente 4b einen Fehlerindikator 3c direkt zum Fehlerindikator 3b aufweisen.

Im Vergleich zu herkömmlichen Fehlersuchalgorithmen werden gemäß dem Gegenstand der vorliegenden Erfindung aufgrund des Konzeptes einer virtuellen Komponente 4a, 4b jeder Verbindungsleitung zwischen zwei Komponenten 2a,2b zwei unabhängige Fehlerindikatoren 3b,3c zugeordnet. Dies hat den Vorteil, dass eine Form der Normierung der Fehlerindikatoren 3a,3b vorgenommen wird.

In der Figur FIG. 1b ist eine anders zusammengesetzte virtuelle Komponente 4a dargestellt. Zwischen zwei Komponenten 2a,2b dient die Versorgungsleitung 1 des elektrischen Versorgungsnetzes als Verbindung. Ein möglicher Fehler 7 auf diesem Abschnitt der Versorgungsleitung 1 wird durch zwei Fehlerindikatoren 3b,3c ermittelt, die den Komponenten 2a,2b jeweils zugeordnet sind. Jeder Verbindungsleitung wird jeweils ein Fehlerindikator 3b,3c zugeordnet, so dass im Falle einer Verbindung von drei Komponente 2a bis 2c über einen Kotenpunkt innerhalb des elektrischen Versorgungsnetzes die entsprechende virtuelle Komponente 4a drei Fehlerindikatoren 3a bis 3c aufweist.

Aufgrund der Ermittlung der Richtung des Fehlers 7 (nicht dargestellt), insbesondere eines Erdschlusses, können aufgrund der damit verbundenen Korrelationskoeffizienten 5b,5c (nicht dargestellt) bezüglich des Fehler 7 korreliert und hieraus die Fehlerindikatoren 3b,3c mit den entsprechenden Korrelationskoeffzienten 5b,5c insgesamt für die virtuelle Komponente 4a als Index 6a normiert werden. Für den Fall, dass die Richtung des Fehlers 7 von der Komponente 2a wegzeigt wird ein Zahl -1, für den Fall das die Richtung des Fehlers 7 in die Komponente 2a zeigt eine Zahl +1 als Korrelationskoeffizient 5b vergeben. Die virtuelle Komponente 4a, in der der Fehler 7 auftritt, enthält damit nur Korrelationskoeffizienten 5b,5c mit der Zahl +1, so dass hier der höchste Fehlerindex 6a vorliegt und damit die höchste Wahrscheinlichkeit für das Auftreten eines Fehlers 7 in diesem Abschnitt des elektrischen Versorgungsnetzes.

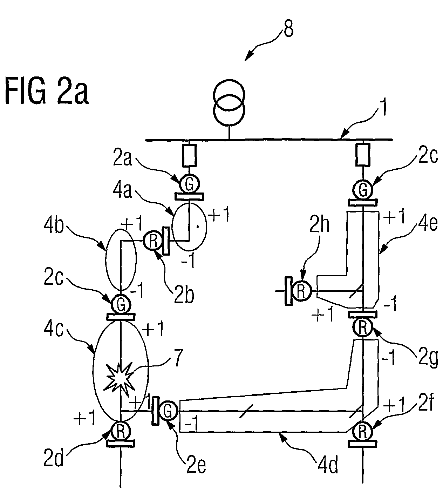

Die Figur FIG.2a zeigt einen Ausschnitt eines exemplarischen Versorgungsnetzes, dass über zwei Leistungsschalter 2a,2i mit einer nicht zu überwachenden Hauptspannungsleitung über eine Transformator 8 verbunden ist. Im vorliegenden Fall wird davon ausgegangen, dass die Leistungsschalter 2a,2i und der Transformator 8 nicht hinsichtlich möglicher Fehler 6 zu überwachen sind.

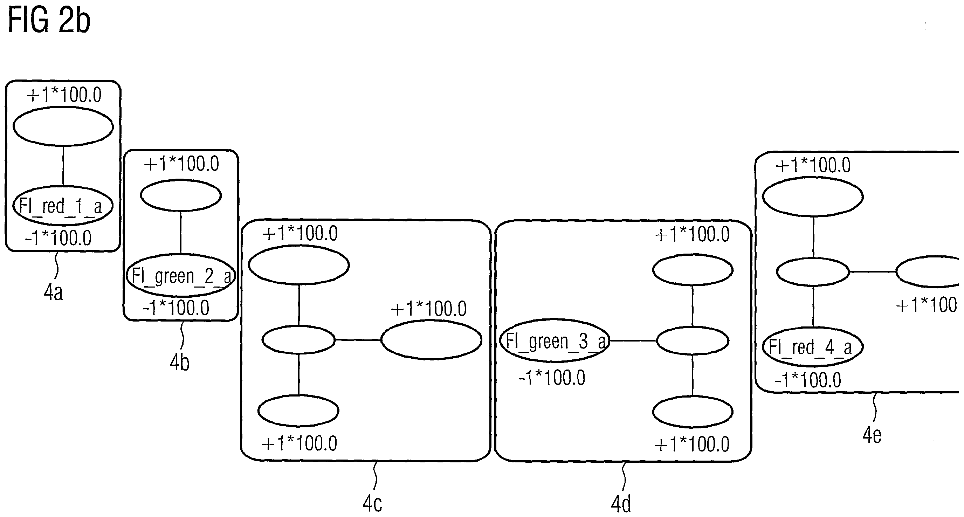

Das zu überwachende elektrische Versorgungsnetz ist im vorliegenden Beispiel in fünf virtuelle Komponenten 4a bis 4e unterteilt, die zumindest eine Komponente 2a bis 2i enthalten und in der jeder Zu- oder Ableitung der Versorgungsleitung 1jeweils ein Fehlerindikator 3a bis 31 (nicht dargestellt) zugeordnet ist. In der Darstellung FIG. 2a ist dafür in Abhängigkeit von der Richtung des Fehlers der Korrelationskoeffizienten 5a bis 5i als +1 bzw. als -1 dargestellt.
Die virtuelle Komponente 4c weist einen Knotenpunkt der Versorgungsleitung 1 und damit drei Komponenten 2c,2d,2e auf. Daher sind dieser virtuellen Komponente 4c drei Fehlerindikatoren 3c,2d,3e mit entsprechenden Korrelationskoeffizienten 5c,5d,5e zugeordnet. Da in dieser virtuellen Komponente 4c der Fehler 7 im vorliegenden Beispiel auftritt, sind die entsprechenden Korrelationskoeffizienten 5c,5d,5e aufgrund der Richtung des Fehlers 7 alle +1. In allen anderen virtuellen Komponenten 4a,4b,4d,4e sind nicht alle Korrelationskoeffizienten 5a, 5b, 5f bis 5i durchgängig +1. Dies wird auch aus der Darstellung der einzelnen virtuellen Komponenten 4a bis 4e gemäß der Figur 2b deutlich.

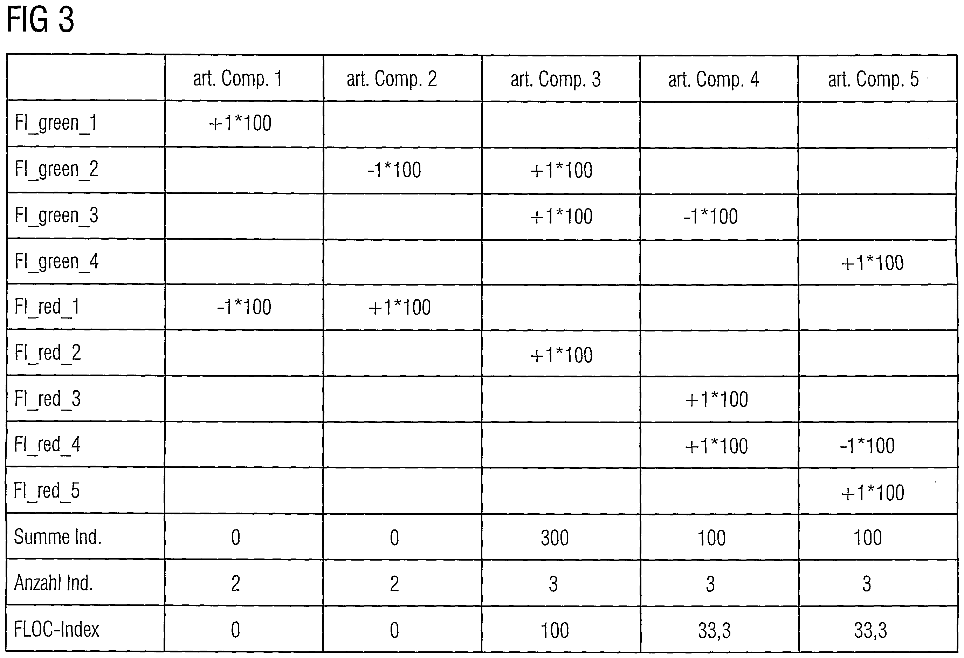

Die Figur 3 zeigt eine tabellarische Darstellung der relevanten Fehlerindikatoren 5a bis 5i der virtuellen Komponenten 4a bis 4e (in der Tabelle als art. Comp.1 bis art. Comp.5). Die einzelnen Komponenten 2a bis 2i sind als Fl-green_1 bis Fl_red_5 dargestellt. In der virtuellen Komponente 4c addieren sich aufgrund des dort aufgetretenen Fehlers 7 (nicht dargestellt) die Fehlerindikator 3c,3d,3e mit dem Wert 100 multipliziert mit den Korrelationskoeffizienten 5c,5d,5e in Form der +1 zu einer Summe, die normiert durch die Anzahl der betrachteten Fehlerindikatoren 5a bis 5i im vorliegenden Beispiel den höchsten Fehlerindex 6c aufweist.

## Patentansprüche

1. Verfahren zur Erfassung eines Fehlers in einem elektrischen Energieversorgungsnetz (1), wobei
• eine Komponente (2a) des elektrischen Versorgungsnetzes mit mindestens einer Versorgungsleitung (1) verbunden, ist wobei die Komponente (2a) mit einem Teil der Zu- und Ableitungen der Versorgungsleitung (1) zur Komponente (2a) zu einer virtuellen Komponente (4a) zusammengefasst wird,
• jeder der mit der Komponente (2a) verbundenen Versorgungsleitung (1) innerhalb der virtuellen Komponente (4a) ein Fehlerindikator (3a) zugeordnet wird,
• eine Richtung eines möglichen Fehlers (7), insbesondere eines Erdschlusses, ermittelt wird,
**gekennzeichnet durch** die Schritte, dass
• jedem Fehlerindikator (3a) in Abhängigkeit von der Richtung des Fehlers (6) ein Korrelationskoeffizient (5a) zugewiesen wird,
• die mit dem Korrelationskoeffizienten zugeordneten Fehlerindikatoren (3a, 3b) einer virtuellen Komponente (4a) zu einem Index (5a) zusammengefasst werden, wobei
• zumindest zwei Indizes (6a,6b) von virtuellen Komponenten (4a, 4b) miteinander verglichen werden, wobei
• die virtuelle Komponente (4a) mit der höchsten Fehlerwahrscheinlichkeit ermittelt wird.

2. Verfahren nach Anspruch 1,
**dadurch gekennzeichnet, dass**
die Indizes (5a,5b,5c,5d,5e) der virtuellen Komponenten (4a, 4b,4c,4d,4e)bezüglich jeweils einer funktionellen Gruppe von Komponenten (2a,2b,2c,2d,2e,2f,2g,2h,2i) berechnet werden.

3. Verfahren nach einem der Ansprüche 1 oder 2,
**dadurch gekennzeichnet , dass**
die Fehlerindikatoren (4a,4b,4c,4d,4e) hinsichtlich ihrer Anzeigegenauigkeit innerhalb des elektrischen Versorgungsnetzes gewichtet sind.

4. Verfahren nach einem der Ansprüche 1 bis 3,
**dadurch gekennzeichnet , dass**
der Fehlerindikator (3a) einem alphanumerischen Wert entspricht.

5. Verfahren nach einem der Ansprüche 1 bis 4,
**dadurch gekennzeichnet , dass**
die Fehlerindikatoren (3a,3b) einer virtuellen Komponente (4a) addiert und bezüglich der Anzahl der Fehlerindikatoren (3a, 3b) normiert werden und einen entsprechenden Index (5a) ergeben.

6. Verfahren nach einem der Ansprüche 1 bis 5,
**dadurch gekennzeichnet, dass**
die virtuelle Komponente (4a) mit dem höchsten Index (5a) automatisch ausgewählt und/oder einem Betrachter visualisiert wird.

7. Verfahren nach einem der Ansprüche 1 bis 6,
**dadurch gekennzeichnet , dass** in periodischen Abständen die Richtung eines möglichen Fehlers (7) ermittelt wird.

8. Vorrichtung zur Durchführung des Verfahrens nach einem der Ansprüche 1 bis 7.

9. Computerprogrammprodukt, das in einem computerlesbaren Medium gespeichert ist und computerlesbare Mittel umfasst, mittels derer ein Computer veranlasst wird, ein Verfahren nach einem der vorhergehenden Ansprüche 1 bis 7 durchzuführen, wenn das Programm in dem Computer abläuft.

## Claims

1. Method for detection of a fault in an electrical power supply system (1), wherein
• one component (2a) of the electrical supply system is connected to at least one supply line (1), with the component (2a) being combined with some of the input lines and output lines of the supply line (1) to the component (2a) to form a virtual component (4a),
• a fault indicator (3a) is associated with each supply line (1), which is connected to the component (2a) within the virtual component (4a),
• a direction of a possible fault (7), in particular of a ground short is determined,
**characterized by** the steps that
• each fault indicator (3a) is assigned a correlation coefficient (5a) as a function of the direction of the fault (6),
• the fault indicators (3a, 3b) of a virtual component (4a) which are associated with the correlation coefficient are combined to form an index (5a), with
• at least two indices (6a, 6b) of virtual components (4a, 4b) being compared with one another, with
• the virtual component (4a) having the highest fault probability being determined.

2. Method according to Claim 1,
**characterized in that**
the indices (5a, 5b, 5c, 5d, 5e) of the virtual components (4a, 4b, 4c, 4d, 4e) are calculated with respect to in each case one functional group of components (2a, 2b, 2c, 2d, 2e, 2f, 2g, 2h, 2i).

3. Method according to one of Claims 1 or 2,
**characterized in that**
the fault indicators (4a, 4b, 4c, 4d, 4e) are weighted with respect to their indication accuracy within the electrical supply system.

4. Method according to one of Claims 1 to 3,
**characterized in that**
the fault indicator (3a) corresponds to an alpha numeric value.

5. Method according to one of Claims 1 to 4,
**characterized in that**
the fault indicators (3a, 3b) of one virtual component (4a) are added and normalized with respect to the number of fault indicators (3a, 3b), and result in a corresponding index (5a).

6. Method according to one of Claims 1 to 5,
**characterized in that**
the virtual component (4a) with the highest index (5a) is automatically selected and/or is displayed to an observer.

7. Method according to one of Claims 1 to 6,
**characterized in that**
the direction of a possible fault (7) is determined at periodic intervals.

8. Apparatus for carrying out the method according to one of Claims 1 to 7.

9. Computer program product, which is stored in a computer-legible medium and comprises computer-legible means, by means of which a computer is caused to carry out a method according to one of the preceding Claims 1 to 7, when the program is run in the computer.

## Revendications

1. Procédé de détection d'un défaut dans un réseau (1) d'alimentation en énergie électrique, dans lequel
• un composant (2a) du réseau d'alimentation électrique est relié à au moins une ligne (1) d'alimentation,
dans lequel on réunit, en un composant (4a) virtuel, le composant (2a) à une partie des lignes d'entrée et de sortie de la ligne (1) d'alimentation du composant (2a),
• on associe un indicateur (3a) de défaut, au sein du composant (4a) virtuel, à chaque ligne (1) d'alimentation reliée au composant (2a),
• on détermine un sens d'un défaut (7) éventuel, notamment d'une mise à la terre,
**caractérisé par** les stades suivant lesquels
• on affecte un coefficient (5a) de corrélation à chaque indicateur (3a) de défaut en fonction du sens du défaut (6),
• on réunit, en un indice (5a), les indicateurs (3a, 3b) de défaut, associés au coefficient de corrélation, d'un composant (4a) virtuel, dans lequel
• on compare entre eux au moins deux indices (6a, 6b) de composants (4a, 4b) virtuels, dans lequel
• on détermine le composant (4a) virtuel ayant la probabilité de défaut la plus grande.

2. Procédé suivant la revendication 1,
**caractérisé en ce que**
l'on calcule les indices (5a, 5b, 5c, 5d, 5^{e}) des composants (4a, 4b, 4c, 4d, 4e) virtuels, rapportés respectivement à un groupe fonctionnel de composants (2a, 2b, 2c, 2d, 2e, 2f, 2g, 2h, 2i).

3. Procédé suivant l'une des revendications 1 ou 2,
**caractérisé en ce que**
l'on pondère, dans le réseau d'alimentation électrique, les indicateurs (4a, 4b, 4c, 4d, 4e) de défaut en ce qui concerne leur précision d'indication.

4. Procédé suivant l'une des revendications 1 à 3,
**caractérisé en ce que**
l'indicateur (3a) de défaut correspond à une valeur alphanumérique.

5. Procédé suivant l'une des revendications 1 à 4,
**caractérisé en ce que**
les indicateurs (3a, 3b) de défaut d'un composant (4a) virtuel sont additionnés et sont normés en ce qui concerne le nombre des indicateurs (3a, 3b) de défaut et donnent un indice (5a) correspondant.

6. Procédé suivant l'une des revendications 1 à 5,
**caractérisé en ce que**
l'on choisit automatiquement le composant (4a) virtuel ayant l'indice (5a) le plus grand et/ou on le visualise pour un observateur.

7. Procédé suivant l'une des revendications 1 à 6,
**caractérisé en ce que**
l'on détermine, à des intervalles périodiques, le sens d'un défaut (7) éventuel.

8. Dispositif pour effectuer le procédé suivant l'une des revendications 1 à 7.

9. Produit de programme d'ordinateur, qui est mémorisé dans un support déchiffrable par ordinateur et qui comprend des moyens pouvant être déchiffrés par un ordinateur et au moyen desquels un ordinateur fait qu'un procédé suivant l'une des revendications précédentes 1 à 7 est effectué, lorsque le programme se déroule dans l'ordinateur.
